(19) Europäisches Patentamt

European Patent Office

Office européen des brevets

(11) **EP 2 407 963 B1**

(12) **EUROPEAN PATENT SPECIFICATION**

(45) Date of publication and mention
of the grant of the patent:
**13.05.2015 Bulletin 2015/20**

(21) Application number: **09841315.6**

(22) Date of filing: **11.03.2009**

(51) Int Cl.:
*H03M 7/30* (2006.01)          *G10L 19/022* (2013.01)
*G10L 19/04* (2013.01)

(86) International application number:
**PCT/CN2009/070729**

(87) International publication number:
**WO 2010/102446 (16.09.2010 Gazette 2010/37)**

(54) **LINEAR PREDICTION ANALYSIS METHOD, APPARATUS AND SYSTEM**

VERFAHREN, VORRICHTUNG UND SYSTEM ZUR LINEARPRÄDIKTIONSANALYSE

PROCÉDÉ, DISPOSITIF ET SYSTÈME D'ANALYSE PAR PRÉDICTION LINÉAIRE

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(43) Date of publication of application:
**18.01.2012 Bulletin 2012/03**

(73) Proprietor: **Huawei Technologies Co., Ltd.
Longgang District
Shenzhen, Guangdong 518129 (CN)**

(72) Inventors:
• **XU, Jianfeng
Guangdong 518129 (CN)**
• **MIAO, Lei
Guangdong 518129 (CN)**
• **QI, Fengyan
Guangdong 518129 (CN)**
• **ZHANG, Dejun
Guangdong 518129 (CN)**
• **ZHANG, Qing
Guangdong 518129 (CN)**

(74) Representative: **Kreuz, Georg Maria et al
Huawei Technologies Duesseldorf GmbH
Messerschmittstrasse 4
80992 München (DE)**

(56) References cited:
CN-A- 1 338 096          CN-A- 1 387 131
CN-A- 1 732 530          US-A- 5 848 391
US-A1- 2003 139 830      US-A1- 2004 083 096
US-A1- 2006 173 675      US-A1- 2007 118 368
US-A1- 2008 270 124      US-A1- 2008 312 914
US-B1- 6 311 154          US-B1- 6 978 236

• LEV O ET AL: "Low bit-rate speech coder based
on a long-term model", ELECTRICAL AND
ELECTRONICS ENGINEERS IN ISRAEL, 2002.
THE 22ND CONVENT ION OF DEC. 1, 2002,
PISCATAWAY, NJ, USA,IEEE, 1 January 2002
(2002-01-01), pages 16-18, XP010631028, ISBN:
978-0-7803-7693-9

**Description**

**FIELD OF THE INVENTION**

The present invention relates to communication technologies, and in particular, to a method, an apparatus, and a system for Linear Prediction Coding (LPC) analysis.

**BACKGROUND OF THE INVENTION**

In order to save bandwidth for transmitting and storing voice and audio signals, voice and audio coding technologies are applied widely, for example, lossy coding and lossless coding. In the lossy coding, the reconstructed signals are not completely the same as the original signals, but redundant information of signals may be minimized according to the sound source features and the human perception features. In the lossless coding, the reconstructed signals need to be completely the same as the original signals so that the final decoding quality is not impaired at all. Generally, in the lossy coding, the compression ratio is high, but the quality of the reconstructed voice may not be ensured; in the lossless coding, the voice quality is ensured, but the compression ratio is as low as about 50%.

In both the lossy coding and the lossless coding, an LPC (Linear Prediction Coding) model is widely applied to voice coding. In the lossy coding, a typical application of the LPC model is Code Excited Linear Prediction (CELP) coding model. The fundamentals of the CELP coding model are: remove the near sample point redundancy of voice signals by using short-time linear prediction, remove the far sample point redundancy of voice signals by using a long-time predictor, and perform coded transmission for parameters generated in the prediction process and residual signals obtained through the two levels of prediction.

Currently, the LPC analysis of lossy and lossless audio coding/decoding generally involves three modules: windowing module, auto-correlation module, and Levinson algorithm module. Residual signals are obtained through linear prediction, and are coded through entropy coding to implement audio compression.

In the process of LPC, the prior art at least exists the following problems:

A fixed window function is applied in the windowing process, which makes the linear prediction performance not optimal.

Alternatively, the input signals undergo two rounds of LPC analysis; in the first round of LPC analysis, a short window is applied to the signals; in the second round of LPC analysis, a long window is applied to the signals, which increases complexity of the LPC analysis.

The document US 6311154 B1 discloses a speech coder and a method for speech coding, wherein the speech signal is represented by an excitation signal applied to a synthesis filter. The speech is partitioned into frames and subframes. A classifier identifies which of several categories the speech frame belongs to, and a different coding method is applied to represent the excitation for each category. For some categories, one or more windows are identified for the frame where all or most of the excitation signal samples are assigned by a coding scheme. Performance is enhanced by coding the important segments of the excitation more accurately. The window locations are determined from a linear prediction residual by identifying peaks of the smoothed residual energy contour. The method adjusts the frame and subframe boundaries so that each window is located entirely within a modified subframe or frame. This eliminates the artificial restriction incurred when coding a frame or subframe in isolation, without regard for the local behavior of the speech signal across frame or subframe boundaries.

The document US 2007/118368 A1 discloses an audio encoding apparatus comprising: a power calculation unit that calculates a power fluctuation ratio based on the input signal; a calculation unit that calculates a prediction gain fluctuation ratio based on the input signal; and a block length judging unit that selects one of encoding using a long block mode segmenting an input signal into frames each consisting of a predetermined number of samples and encoding each of the frames, and encoding using a short block mode segmenting each of the frames into short blocks and encoding each of the short blocks, based on the power fluctuation ratio and the prediction gain fluctuation ratio.

The document US 2006/173675 A1 discloses methods and units for supporting a switching from a first coding scheme to a Modified Discrete Cosine Transform (MDCT) based coding scheme calculating a forward or inverse MDCT with a window (h(n)) of a first type for a respective coding frame, which satisfies constraints of perfect reconstruction. To avoid discontinuities during the switching, it is proposed that for a transient frame immediately after a switching, a sequence of windows (h0(n),hl(n),h2(n)) is provided for the forward and the inverse MDCTs. The windows of the window sequence are shorter than windows of the first type. The window sequence splits the spectrum of a respective first coding frame into nearly uncorrelated spectral components when used as basis for forward MDCTs, and the second half of the last window (h2(n)) of the sequence of windows is identical to the second half of a window of the first type.

The document US 6978236 B1 discloses a new method and an apparatus for spectral envelope encoding. The prior art teaches how to perform and signal compactly a time/frequency mapping of the envelope representation, and further, encode the spectral envelope data efficiently using adaptive time/frequency directional coding. The method is applicable to both natural audio coding and speech coding systems and is especially suited for coders using SBR [WO 98/57436] or other high frequency reconstruction methods.

LEV O ET AL: "Low Bit-Rate Speech Coder Based on a Long-Term Model" discloses that we present a low bit rate speech coder based on a long-term model (LTM) for voiced speech, and on the WI coder. In the LTM, a periodic input signal undergoes a time-varying spectral shaping representing the evolution of the pitch-cycle waveform. The resulting signal, which has a fixed pitch period but a time-varying pitch-cycle waveform, is multiplied by a time-varying gain function that represents the variation in speech loudness. The resulting signal then undergoes a time-axis warping, which represents the evolution of the pitch period, yielding the output speech signal. The spectral shaping in the proposed coder is based on WI. In WI, speech (or LPC residual) is observed as a continuously evolving sequence of pitch cycle waveforms. A subset of these waveforms is extracted and coded. In the decoder, after inverse quantization, missing waveforms are synthesized by interpolation. The extracted waveforms are normalized to a fixed length and sequentially aligned using a cyclical shift. Then, a two-dimensional surface, called prototype waveform surface or characteristic waveform (CW) is produced from these waveforms (see abstract).

US Patent Application US2008270124A1 discloses a method of encoding an audio/speech signal is provided, the method including determining a variable length of a frame, that is, a processing unit of an input signal in accordance with a position of an attack in the input signal; transforming each frame of the input signal to a frequency domain and dividing the frame into a plurality of sub frequency bands; and, if a signal of a sub frequency band is determined to be encoded in the frequency domain, encoding the signal of the sub frequency band in the frequency domain, and if the signal of the sub frequency band is determined to be encoded in a time domain, inverse transforming the signal of the sub frequency band to the time domain and encoding the inverse transformed signal in the time domain. According to the present invention, the audio/speech signal may be efficiently encoded by controlling time resolution and frequency resolution (see abstract).

US Patent Application US20030139830A1 discloses an information extraction apparatus capable of analyzing an acoustic signal with accuracy and high efficiency. An amplitude analysis section 32 determines whether or not an attack or release is contained on the basis of an amplitude value for each small region of an input time-series signal. When it is determined that there is an attack or release, an analysis region setting section 33 sets the portion from an attack position to a release position as an analysis region. A frequency analysis section 34 analyzes the input time-series signal by generalized harmonic analysis and outputs extracted waveform information. An extracted waveform synthesis section 35 synthesizes the extracted waveform information and outputs the information to a time-series compensation section 36. The time-series compensation section 36 compensates the signal of the synthesized result with a signal outside the analysis region and outputs an extracted waveform time-series signal to a subtraction unit 37. The subtraction unit 37 generates a residual time-series signal from the input time-series signal and the extracted waveform time-series signal. The present invention can be applied to various audio apparatuses, voice recognition apparatuses, voice synthesis apparatuses, etc., for processing an acoustic signal (see abstract).

US Patent Application 20080312914A1 discloses a time shift calculated during a pitch-regularizing (PR) encoding of a frame of an audio signal is used to time-shift a segment of another frame during a non-PR encoding (see abstract).

## SUMMARY OF THE INVENTION

The embodiments of the present invention provide a method, an apparatus and a system for LPC analysis to improve linear prediction performance and simplify analysis operation.

An LPC analysis method includes:

> obtaining (S201) signal feature information of at least one sample point of an input voice signal;
> comparing and analyzing (S202) the signal feature information to obtain an analysis result;
> selecting a window function, according to the analysis result, to perform adaptive windowing for the input voice signal and obtain a windowed voice signal; and
> processing (S203) the windowed voice signal to obtain an LPC coefficient for linear prediction;
> wherein obtaining (S201) signal feature information of at least one sample point of an input voice signal comprises:
> obtaining (S201) an amplitude value $|x[0]|$ of a first sample point and an amplitude value $|x[N\text{-}1]|$ of a last sample point of the input voice signal, where $x[i]$, $i$ = 0,1,..., $N$-1 are sample points of the input voice signal and N is the number of sample points of the input voice signal; and
> wherein comparing and analyzing (S202) the signal feature information to obtain an analysis result and selecting a window function, according to the analysis result, to perform adaptive windowing for the input voice signal and obtain a windowed voice signal comprises:

analyzing (S202) the amplitude values $|x[0]|$ and $|x[N-1]|$ of the sample points and perform adaptive windowing for the input voice signal according to the analysis result, wherein when the number of sample points of the input voice signal is 80,

if the amplitude value $|x[0]|$ of the first sample point of the input voice signal is less than a preset threshold *thr*, the first 8 points of the window function are set as: $w(n) = 0.26 + 0.74 \cdot \cos(2 \cdot \pi \cdot (31 - 4 \cdot n) /127)$, $n = 0,1,2,...,7$ ; otherwise, the first 8 points of the window function are set as: $w(n) = 0.16 + 0.84 \cdot \cos(2. \pi \cdot (31 - 4 \cdot n) /127)$, $n = 0,1,2,...,7$ ;

the 9th to 72nd points of the window function are set as $w(n) =1$, $n = 8,...,71$ ; if the amplitude value $|x[79]|$ of the last sample point of the input voice signal is less than the preset threshold *thr*, the last 8 points of the window function are set as: $w(n) = 0.26 + 0.74 \cdot \cos(2 \cdot \pi \cdot (4 \cdot n - 285) /127)$, $n = 72,73,74,...,79$ ; otherwise, the last 8 points of the window function are set as: $w(n) = 0.16 + 0.84 \cdot \cos(2. \pi \cdot (4 \cdot n - 285) / 127$, $n = 72,73,74,...,79$ ; and wherein the sample points of the input voice signal $x(n)$, $n = 0,1,...,78,79$ are windowed by using the window function $w(n)$, $n = 0,1,...,78,79$ to obtain the windowed voice signal

Through the LPC analysis method provided in the present invention, the input signals are analyzed to obtain an analysis result, and a window function required for windowing is allocated adaptively according to the analysis result. In this way, the prediction performance of LPC is improved with little increased complexity of coding.

An LPC analysis apparatus includes:

an obtaining unit (901), configured to obtain signal feature information of at least one sample point of an input voice signal;

an analyzing unit (902), configured to compare and analyze the signal feature information to obtain an analysis result;

a windowing unit (903), configured to select a window function according to the analysis result to perform adaptive windowing for the input voice signal and obtain a windowed voice signal; and

a processing unit (904), configured to process the windowed voice signal to obtain an LPC coefficient for linear prediction;

wherein to obtain signal feature information of at least one sample point of an input voice signal comprises to obtain an amplitude value $|x[0]|$ of a first sample point and an amplitude value $|x[N-1]|$ of a last sample point of the input voice signal, where $x[i]$, $i = 0,1,..., N-1$ are sample points of the input voice signal and N is the number of sample points of the input voice signal;

wherein to compare and analyze the signal feature information to obtain an analysis result and to select a window function according to the analysis result to perform adaptive windowing for the input voice signal and obtain a windowed voice signal comprises to analyze the amplitude values $|x[0]|$ and $|x[N-1]|$ of the sample points and to perform adaptive windowing for the input voice signal according to the analysis result; wherein when the number of sample points of the input voice signal is 80,

if the amplitude value $|x[0]|$ of the first sample point of the input voice signal is less than a preset threshold *thr*, the first 8 points of the window function are set as: $w(n) = 0.26 + 0.74 \cdot \cos(2 \cdot \pi \cdot (31 - 4 \cdot n) /127)$, $n = 0,1,2,...,7$ ; otherwise, the first 8 points of the window function are set as: $w(n) = 0.16 + 0.84 \cdot \cos(2 \cdot \pi \cdot (31 - 4 \cdot n) /127)$, $n = 0,1,2,...,7$ ;

the 9th to 72nd points of the window function are set as $w(n) =1$, $n = 8,...,71$;

if the amplitude value $|x[79]|$ of the last sample point of the input voice signal is less than the preset threshold *thr*, the last 8 points of the window function are set as: $w(n) = 0.26 + 0.74 \cdot \cos(2 \cdot \pi \cdot (4 \cdot n - 285) /127)$, $n = 72,73,74,...,79$ ; otherwise, the last 8 points of the window function are set as: $w(n) = 0.16 + 0.84 - \cos(2 \cdot \pi \cdot (4 \cdot n - 285) /127)$, $n = 72,73,74,...,79$ ; and wherein the sample points of the input voice signal $x(n)$, $n = 0,1,...,78,79$ are windowed by using the window function $w(n)$, $n = 0,1,...,78,79$ to obtain the windowed voice signal.

The LPC analysis apparatus provided in embodiments of the present invention are configured to analyze the input signals to obtain an analysis result, and allocate adaptively a window function required for windowing according to the analysis result. In this way, the prediction performance of LPC is improved with little increased complexity of coding.

An LPC system includes:

an LPC analysis apparatus according to an embodiment of the present invention; and

a coding apparatus, configured to perform coding according to the LPC coefficient obtained by the LPC analysis apparatus.

Through the LPC system provided in embodiments of the present invention, the input signals are analyzed to obtain an analysis result, and a window function required for windowing is performed according to the LPC coefficient. In this way, the prediction performance of LPC is improved with little increased complexity of coding.

BRIEF DESCRIPTION OF THE DRAWINGS

To make embodiments of the present invention or technical solutions in the prior art clearer, the following outlines the accompanying drawings involved in the embodiments of the present invention or the prior art. Apparently, the accompanying drawings outlined below are illustrative rather than exhaustive, and persons of ordinary skill in the art can derive other drawings from them ) without any creative effort.

FIG. 1 is a block flowchart of an LPC analysis method according to an embodiment of the present invention;

FIG. 2 is a block flowchart of an LPC analysis method according to a first embodiment of the present invention;

FIG. 3 is a block flowchart of an LPC analysis method according to a first example;

FIG. 4 is a block flowchart of an LPC analysis method according to a second example;

FIG. 5 is a block flowchart of an LPC analysis method according to a third example;

FIG. 6 is a block flowchart of an LPC analysis method according to a fourth example;

FIG. 7 is a block flowchart of an LPC analysis method according to a fifth example;

FIG. 8 is a block flowchart of an LPC analysis method according to a sixth example;

FIG. 9 is a structure block diagram of an LPC analysis apparatus according to an embodiment of the present invention;

FIG. 10 is a structure block diagram of an LPC analysis apparatus according to another ) embodiment of the present invention;

FIG. 11 is a structure block diagram of an LPC system according to an embodiment of the present invention; and

FIG. 12 is a structure block diagram of an LPC system according to another embodiment of the present invention.

## DETAILED DESCRIPTION OF THE EMBODIMENTS

The following detailed description is given in conjunction with the accompanying drawings to provide a thorough understanding of the present invention. Evidently, the described embodiments are merely part of rather than all embodiments.. Other embodiments, which can be derived by those skilled in the art from the embodiments given herein without any creative effort, may fall within the scope of the present invention as defined by the appended claims.

The embodiments of the present invention provide a method, an apparatus and a system for LPC analysis to improve linear prediction performance and simplify analysis operation.

The embodiments of the present invention are described in detail below with reference to accompanying drawings.

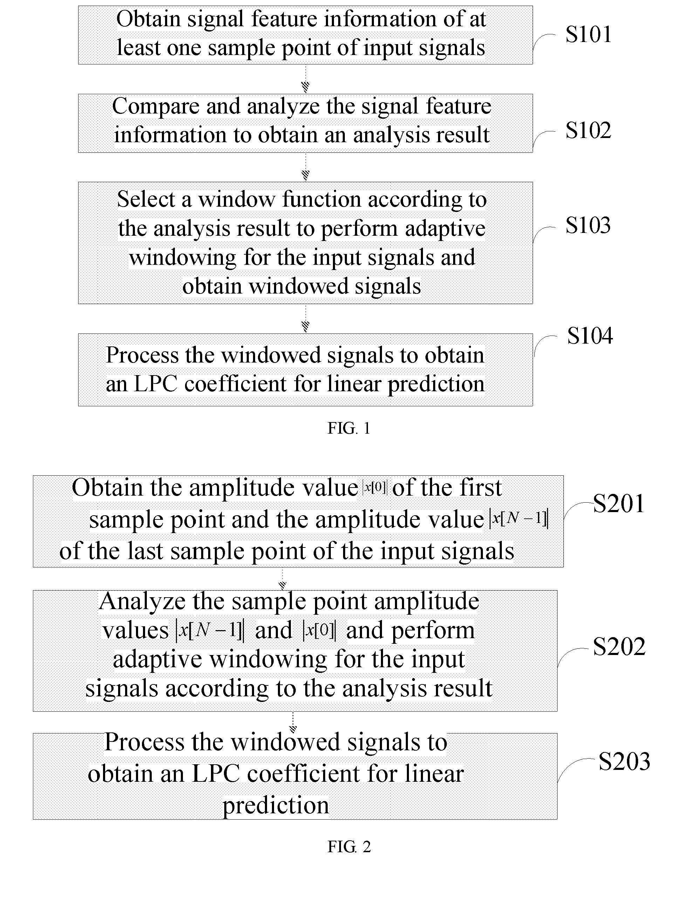

As shown in FIG. 1, an LPC analysis method provided in an embodiment of the present invention includes the following steps:

S101. Obtain signal feature information of at least one sample point of an input signal.
S102. Compare and analyze the signal feature information to obtain an analysis result.
S103. Select a window function according to the analysis result to perform adaptive windowing for the input signal and obtain windowed signals.
S104. Process the windowed signals to obtain an LPC coefficient for linear prediction.

Through the LPC analysis method provided herein, the input signal are analyzed to obtain an analysis result, and a window function required for windowing is allocated adaptively according to the analysis result. In this way, the prediction performance of LPC is improved with little increased complexity of coding.

The information feature information includes any one or any combination of: amplitude, energy, zero-crossing rate, signal type, frame length, coding mode.

The method is described with the following embodiment of the present invention.

**Embodiment 1**

As shown in FIG. 2, an LPC analysis method provided in the first embodiment of the present invention includes the following steps:

S201. Obtain an amplitude value $|x[0]|$ of a first sample point and an amplitude value $|x[N\text{-}1]|$ of a last sample point of an input signal, where $x[i]$, $i$ = 0,1,..., $N$-1 are an input signal, $N$ is the number (such as 40, 80, 160, 240, or 320) of sample points of the input signal. The input signal herein refer to signals input for LPC analysis, and may be a frame of signals, or may be a frame of signals plus a segment of signals in a history buffer (such as L sample points in the history buffer, where L is a positive integer such as 40, 80, 160, 240, or 320, according to the type of codec). S202. Analyze amplitude values $|x[0]|$ and $|x[N\text{-}1]|$ of the sample point and perform adaptive windowing for the input signal according to the analysis result.

For example, when the number of sample points of the input signal is 40:

If the amplitude value $|x[0]|$ of the first sample point of the input signal is less than a preset threshold $thr$ (such as $thr$ =128), the first 4 points of the window function are set as:

$$w(n) = 0.23 + 0.77 \cdot \cos(2 \cdot \pi \cdot (31 - 8 \cdot n)/127), \quad n = 0,1,2,3 .$$

Otherwise, the first 4 points of the window function are set as:

$$w(n) = 0.26 + 0.74 \cdot \cos(2 \cdot \pi \cdot (31 - 8 \cdot n)/127) \quad n = 0,1,2,3$$

Points 5-36 of the window function are set to Is, namely,

$$w(n) = 1 \quad n = 4,...,35 .$$

If the amplitude value $|x[39]|$ of the last sample point of the input signal is less than a preset threshold $thr$ (such as $thr$ = 128), the last 4 points of the window function are set as:

$$w(n) = 0.23 + 0.77 \cdot \cos(2 \cdot \pi \cdot (8 \cdot n - 281)/127) \quad n = 36,37,38,39 .$$

Otherwise, the last 4 points of the window function are set as:

$$w(n) = 0.26 + 0.74 \cdot \cos(2 \cdot \pi \cdot (8 \cdot n - 281)/127) \quad n = 36,37,38,39 .$$

Afterward, signals $x(n)$, $n$ = 1,2,...,38,39 are windowed by using the adaptively set window function $w(n)$, $n$ = 1,2,...,38,39 namely,

$$xd[n] = x[n] \cdot w[n] \quad n = 0,1,...,38,39$$

As a result, the adaptively windowed signals $xd[n]]$, $n$ = 0,1,...,38,39 are obtained.
According to the embodiment, when the number of sample points of the input signal is 80:

If the amplitude value $|x[0]|$ of the first sample point of the input signal is less than a preset threshold $thr$ (such as $thr$ = 128), the first 8 points of the window function are set as:

$$w(n) = 0.26 + 0.74 \cdot \cos(2 \cdot \pi \cdot (31 - 4 \cdot n)/127) \quad n = 0,1,2,...,7$$

Otherwise, the first 8 points of the window function are set as:

$$w(n) = 0.16 + 0.84 \cdot \cos(2 \cdot \pi \cdot (31 - 4 \cdot n)/127) \quad n = 0,1,2,...,7$$

Points 9-72 of the window function are set to 1s, namely,

$$w(n) = 1 \quad n = 8,...,71 .$$

If the amplitude value $|x[79]|$ of the last sample point of the input signal is less than a preset threshold *thr* (such as *thr* = 128), the last 8 points of the window function are set as:

$$w(n) = 0.26 + 0.74 \cdot \cos(2 \cdot \pi \cdot (4 \cdot n - 285)/127) \quad n = 72,73,74,...,79 .$$

Otherwise, the last 8 points of the window function are set as:

$$w(n) = 0.16 + 0.84 \cdot \cos(2 \cdot \pi \cdot (4 \cdot n - 285)/127) \quad n = 72,73,74,...,79 .$$

Afterward, signals $x(n)$, $n$ = 0,1,...,78,79 are windowed by using the adaptively set window function $w(n)$, $n$ = 0,1,...,78,79, namely,

$$xd[n] = x[n] \cdot w[n] \quad n = 0,1,...,78,79 .$$

As a result, the adaptively windowed signals $xd[n]]$, $n$ = 0,1,...,78,79 are obtained.

The policy of adjusting the window function $w[n]$ is selected through plenty of experiments according to the type of vocoder.

The threshold *thr* is also selected through plenty of experiments, for example, *thr* = 128 or *thr* = 157.

S203. Process the windowed signals to obtain an LPC coefficient for linear prediction.

Through the LPC analysis method provided in the first embodiment, the amplitude values of the first sample point and the last sample point of the input signal are obtained, and the input signal are windowed adaptively according to the amplitude values of sample points. In this way, the prediction performance of LPC is improved with little increased complexity of coding.

**Example 1**

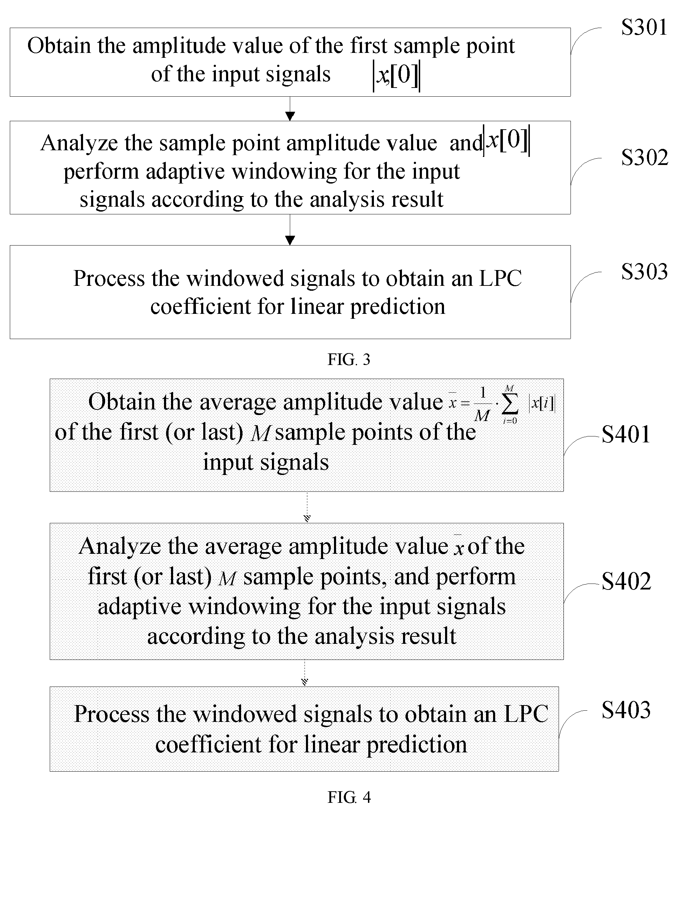

As shown in FIG. 3, an LPC analysis method provided in the first example includes the following steps:

S301. Obtain an amplitude value $|x[0]|$ of a first sample point of an input signal, where $x[i]$, $i$ = 0,1,..., $N$-1 refers to an input signal, and N is the number of sample points of the input signal. The input signal herein refer to signals input for LPC analysis, and may be a frame of signals, or may be a frame of signals plus a segment of signals in a history buffer (such as L sample points in the history buffer, where L is a positive integer, such as 40 or 80, and value of L varies with the type of the codec).

S302. Analyze amplitude value $|x[0]|$ of the sample point and perform adaptive windowing for the input signal according to the analysis result.

If the amplitude value $|x[0]|$ of the first sample point of the input signal is greater than or equal to a preset threshold *thr*, the input signal are windowed by using the first window function, namely, by letting $xd[i]$ be $x[i] \cdot w1[i]$, $i$ = 0,1,..., $N$-1, where $xd[i]$ refers to windowed signals and $w1[i]$ is the first window function.

Otherwise, the input signal are windowed by using the second window function, namely, by letting $xd[i]$ be $x[i] \cdot w2[i]$, $i$ = 0,1,..., $N$-1, where $w2[i]$ is the second window function.

The window function $w1[i]$ and the window function $w2[i]$ may be selected through plenty of experiments according to the type of vocoder, and are applicable to different signals. For example, $w1[i]$ is a sine window and $w2[i]$ is a Hamming window; or, $w1[i]$ is a Hamming window and $w2[i]$ is a sine window. The threshold $thr$ may also be selected through plenty of experiments, for example, $thr$ = 128or $thr$ = 157.

In an instance, $thr$ = 128; and, when the frame length $N$ = 80 ,

$$w1[i] = \begin{cases} 0.16 + 0.84 \cdot \cos(2 \cdot \pi \cdot (31 - 4 \cdot i)/127), & i = 0,1,...,7 \\ 1, & i = 8,9,...,71 \\ 0.16 + 0.84 \cdot \cos(2 \cdot \pi \cdot (4 \cdot i - 285)/127), & i = 72,73,...,79 \end{cases}$$

$$w2[i] = \begin{cases} 0.26 + 0.74 \cdot \cos(2 \cdot \pi \cdot (31 - 4 \cdot i)/127), & i = 0,1,...,7 \\ 1, & i = 8,9,...,71 \\ 0.26 + 0.74 \cdot \cos(2 \cdot \pi \cdot (4 \cdot i - 285)/127), & i = 72,73,...,79 \end{cases} .$$

When the frame length N = 40,

$$w1[i] = \begin{cases} 0.26 + 0.74 \cdot \cos(2 \cdot \pi \cdot (31 - 8 \cdot i)/127), & i = 0,1,...,3 \\ 1, & i = 4,5,...,35 \\ 0.26 + 0.74 \cdot \cos(2 \cdot \pi \cdot (8 \cdot i - 281)/127), & i = 36,37,...,39 \end{cases}$$

$$w1[i] = \begin{cases} 0.23 + 0.77 \cdot \cos(2 \cdot \pi \cdot (31 - 8 \cdot i)/127), & i = 0,1,...,3 \\ 1, & i = 4,5,...,35 \\ 0.23 + 0.77 \cdot \cos(2 \cdot \pi \cdot (8 \cdot i - 281)/127), & i = 36,37,...,39 \end{cases} .$$

S303. Process the windowed signals to obtain an LPC coefficient for linear prediction. Through the LPC analysis method provided in the first example, the amplitude value of the first sample point of the input signal is obtained, and the input signal are windowed adaptively according to the amplitude value of the sample point. In this way, the prediction performance of LPC is improved with little increased complexity of coding.

## Example 2

As shown in FIG. 4, an LPC analysis method provided in the second example includes the following steps:

S401. Obtain an average amplitude value $\bar{x} = \frac{1}{M} \cdot \sum_{i=0}^{M} |x[i]|$ of the first (or last) M sample points of an input signal, where $x[i]$, $i$ = 0,1,..., $N$-1 refers to an input signal, and N is the number of sample points of the input signal. The input signal herein refer to signals input for LPC analysis, and may be a frame of signals, or may be a frame of signals plus a segment of signals in a history buffer (such as L sample points in the history buffer, where L is a positive integer, such as 40 or 80, and value of L varies with the type of the codec).

S402. Analyze the average amplitude value $\bar{x}$ of the first (or last) M sample points, and perform adaptive windowing for the input signal according to the analysis result.

If the average amplitude value x of the first (or last) M sample points is greater than or equal to a preset threshold $thr$, the input signal are windowed by using the first window function, namely, by letting $xd[i]$ be $x[i] \cdot w1[i]$, $i$ = 0,1,..., $N$-1, where $xd[i]$ refers to windowed signals and $w1[i]$ is the first window function.

Otherwise, the input signal are windowed by using the second window function, namely, by letting $xd[i]$ be $x[i] \cdot w2[i]$, $i$ = 0,1,..., $N$-1, where $w2[i]$ is the second window function.

The window function $w1[i]$ and the window function $w2[i]$ may be selected through plenty of experiments according to the type of vocoder, and are applicable to different signals. For example, $w1[i]$ is a sine window and $w2[i]$ is a Hamming window; or, $w1[i]$ is a Hamming window and $w2[i]$ is a sine window. The threshold $thr$ may also be selected through plenty of experiments, for example, $thr$ = 127 or $thr$ = 152.

In an instance, *thr* = 128 ; and, when the frame length *N* = 80 ,

$$w1[i] = \begin{cases} 0.15 + 0.85 \cdot \cos(2 \cdot \pi \cdot (31 - 4 \cdot i)/127), & i = 0,1,...,7 \\ 1, & i = 8,9,...,71 \\ 0.15 + 0.85 \cdot \cos(2 \cdot \pi \cdot (4 \cdot i - 285)/127), & i = 72,73,...,79 \end{cases}$$

$$w2[i] = \begin{cases} 0.27 + 0.73 \cdot \cos(2 \cdot \pi \cdot (31 - 4 \cdot i)/127), & i = 0,1,...,7 \\ 1, & i = 8,9,...,71 \\ 0.27 + 0.73 \cdot \cos(2 \cdot \pi \cdot (4 \cdot i - 285)/127), & i = 72,73,...,79 \end{cases} .$$

When the frame length N = 40,

$$w1[i] = \begin{cases} 0.26 + 0.74 \cdot \cos(2 \cdot \pi \cdot (31 - 8 \cdot i)/127), & i = 0,1,...,3 \\ 1, & i = 4,5,...,35 \\ 0.26 + 0.74 \cdot \cos(2 \cdot \pi \cdot (8 \cdot i - 281)/127), & i = 36,37,...,39 \end{cases}$$

$$w1[i] = \begin{cases} 0.23 + 0.77 \cdot \cos(2 \cdot \pi \cdot (31 - 8 \cdot i)/127), & i = 0,1,...,3 \\ 1, & i = 4,5,...,35 \\ 0.23 + 0.77 \cdot \cos(2 \cdot \pi \cdot (8 \cdot i - 281)/127), & i = 36,37,...,39 \end{cases} .$$

S403. Process the windowed signals to obtain an LPC coefficient for linear prediction. Through the LPC analysis method provided in the second example, the average amplitude value of the first (or last) M sample points of the input signal is obtained, and the input signal are windowed adaptively according to the average amplitude value. In this way, the prediction performance of LPC is improved with little increased complexity of coding.

**Example 3**

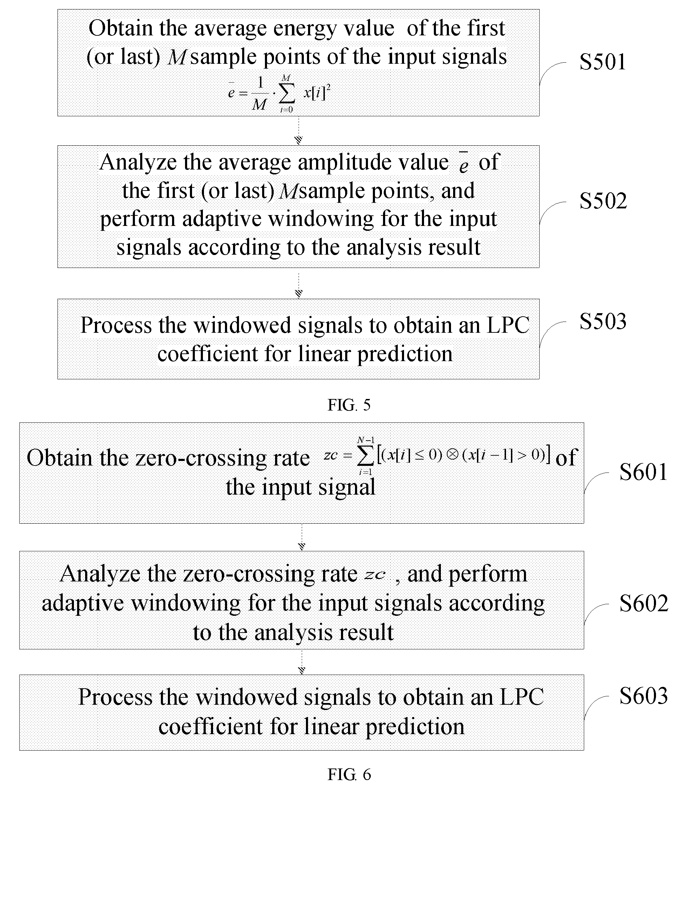

As shown in FIG. 5, an LPC analysis method provided in the third example includes the following steps:

S501. Obtain an average energy value $\overline{e} = \dfrac{1}{M} \cdot \displaystyle\sum_{i=0}^{M} x[i]^2$ of the first (or last) *M* sample points of an input signal, where *x*[*i*], *i* = 0,1,..., *N*-1 refers to the input signal, and *N* is the number of sample points of the input signal.

The input signal herein refer to signals input for LPC analysis, and may be a frame of signals, or may be a frame of signals plus a segment of signals in a history buffer (such as L sample points in the history buffer, where L is a positive integer, such as 40 or 80, and value of L varies with the type of the codec).

S502. Analyze the average energy value e of the first (or last) M sample points, and perform adaptive windowing for the input signal according to the analysis result.

If the average energy value e of the first (or last) *M* sample points is greater than or equal to a preset threshold *thr*, the input signal are windowed by using the first window function, namely, by letting *xd*[*i*] be *x*[*i*] · *w*1[*i*], *i* = 0,1,..., *N*-1, where *xd[i]* refers to windowed signals and *w*1[*i*] is the first window function.
Otherwise, the input signal are windowed by using the second window function, namely, by letting *xd*[*i*] be *x*[*i*] · *w*2[*i*], *i* = 0,1,..., *N*-1, where *w*2[*i*] is the second window function.
The window function *w*1[*i*] and the window function *w*2[*i*] may be selected through plenty of experiments according to the type of vocoder, and are applicable to different signals. For example, *w*1[*i*] is a sine window and *w*2[*i*] is a Hamming window; or, *w*1[*i*] is a Hamming window and *w*2[*i*] is a sine window. The threshold *thr* may also be selected through plenty of experiments, for example, *thr* = 1024 or *thr* = 2573.

In an instance, *thr* = 1280 ; and, when the frame length $N = 80$ ,

$$w1[i] = \begin{cases} 0.18 + 0.82 \cdot \cos(2 \cdot \pi \cdot (31 - 4 \cdot i)/127), & i = 0,1,...,7 \\ 1, & i = 8,9,...,71 \\ 0.18 + 0.82 \cdot \cos(2 \cdot \pi \cdot (4 \cdot i - 285)/127), & i = 72,73,...,79 \end{cases}$$

$$w2[i] = \begin{cases} 0.25 + 0.75 \cdot \cos(2 \cdot \pi \cdot (31 - 4 \cdot i)/127), & i = 0,1,...,7 \\ 1, & i = 8,9,...,71 \\ 0.25 + 0.75 \cdot \cos(2 \cdot \pi \cdot (4 \cdot i - 285)/127), & i = 72,73,...,79 \end{cases} .$$

When the frame length N = 40,

$$w1[i] = \begin{cases} 0.25 + 0.75 \cdot \cos(2 \cdot \pi \cdot (31 - 8 \cdot i)/127), & i = 0,1,...,3 \\ 1, & i = 4,5,...,35 \\ 0.25 + 0.75 \cdot \cos(2 \cdot \pi \cdot (8 \cdot i - 281)/127), & i = 36,37,...,39 \end{cases}$$

$$w1[i] = \begin{cases} 0.24 + 0.76 \cdot \cos(2 \cdot \pi \cdot (31 - 8 \cdot i)/127), & i = 0,1,...,3 \\ 1, & i = 4,5,...,35 \\ 0.24 + 0.76 \cdot \cos(2 \cdot \pi \cdot (8 \cdot i - 281)/127), & i = 36,37,...,39 \end{cases} .$$

S503. Process the windowed signals to obtain an LPC coefficient for linear prediction. Through the LPC analysis method provided in the third example, the average energy value of the first (or last) M sample points of the input signal is obtained, and the input signal are windowed adaptively according to the average energy value. In this way, the prediction performance of LPC is improved with little increased complexity of coding.

**Example 4**

As shown in FIG. 6, an LPC analysis method provided in the fourth example includes the following steps:

S601. Obtain a zero-crossing rate $zc = \sum_{i=1}^{N-1} \left[ (x[i] \leq 0) \otimes (x[i-1] > 0) \right]$ of the input signal, where $x[i]$, $i = 0,1,...,$ N-1 refers to the input signal, $N$ is the number of sample points of the input signal, and $\otimes$ refers to AND operation.

The input signal herein refer to signals input for LPC analysis, and may be a frame of signals, or may be a frame of signals plus a segment of signals in a history buffer (such as L sample points in the history buffer, where L is a positive integer, such as 40 or 80, and value of L varies with the type of the codec).

S602. Analyze the zero-crossing rate *zc*, and perform adaptive windowing for the input signal according to the analysis result.

If the zero-crossing rate *zc* is greater than or equal to a preset threshold *thr*, the input signal are windowed by using the first window function, namely, by letting *xd*[*i*] be *xd*[*i*] = *x*[*i*] · *w*1[*i*], *i* = 0,1,..., *N*-1, where *xd*[*i*] refers to windowed signals and *w*1[*i*] is the first window function.
Otherwise, the input signal are windowed by using the second window function, namely, by letting *xd*[*i*] be *xd*[*i*] = *x*[*i*] · *w*2[*i*], *i* = 0,1,..., *N*-1, where *w*2[*i*] is the second window function.
The window function *w*1[*i*] and the window function *w*2[*i*] may be selected through plenty of experiments according to the type of vocoder, and are applicable to different signals. For example, *w*1[*i*] is a sine window and *w*2[*i*] is a Hamming window; or, *w*1[*i*] is a Hamming window and *w*2[*i*] is a sine window.
The threshold *thr* may also be selected through plenty of experiments, for example, *thr* = 15 or *thr* = 23.
In an instance, *thr* = 18 ; and, when the frame length N = 80,

$$w1[i] = \begin{cases} 0.16 + 0.84 \cdot \cos(2 \cdot \pi \cdot (31 - 4 \cdot i)/127), & i = 0,1,...,7 \\ 1, & i = 8,9,...,71 \\ 0.16 + 0.84 \cdot \cos(2 \cdot \pi \cdot (4 \cdot i - 285)/127), & i = 72,73,...,79 \end{cases}$$

$$w2[i] = \begin{cases} 0.26 + 0.74 \cdot \cos(2 \cdot \pi \cdot (31 - 4 \cdot i)/127), & i = 0,1,...,7 \\ 1, & i = 8,9,...,71 \\ 0.26 + 0.74 \cdot \cos(2 \cdot \pi \cdot (4 \cdot i - 285)/127), & i = 72,73,...,79 \end{cases}.$$

When the frame length $N = 40$,

$$w1[i] = \begin{cases} 0.27 + 0.73 \cdot \cos(2 \cdot \pi \cdot (31 - 8 \cdot i)/127), & i = 0,1,...,3 \\ 1, & i = 4,5,...,35 \\ 0.27 + 0.73 \cdot \cos(2 \cdot \pi \cdot (8 \cdot i - 281)/127), & i = 36,37,...,39 \end{cases}$$

$$w1[i] = \begin{cases} 0.25 + 0.75 \cdot \cos(2 \cdot \pi \cdot (31 - 8 \cdot i)/127), & i = 0,1,...,3 \\ 1, & i = 4,5,...,35 \\ 0.25 + 0.75 \cdot \cos(2 \cdot \pi \cdot (8 \cdot i - 281)/127), & i = 36,37,...,39 \end{cases}.$$

S603. Process the windowed signals to obtain an LPC coefficient for linear prediction.

Through the LPC analysis method provided in the fourth example, the zero-crossing rate of the input signal is obtained, and the input signal are windowed adaptively according to the zero-crossing rate. In this way, the prediction performance of LPC is improved with little increased complexity of coding.

**Example 5**

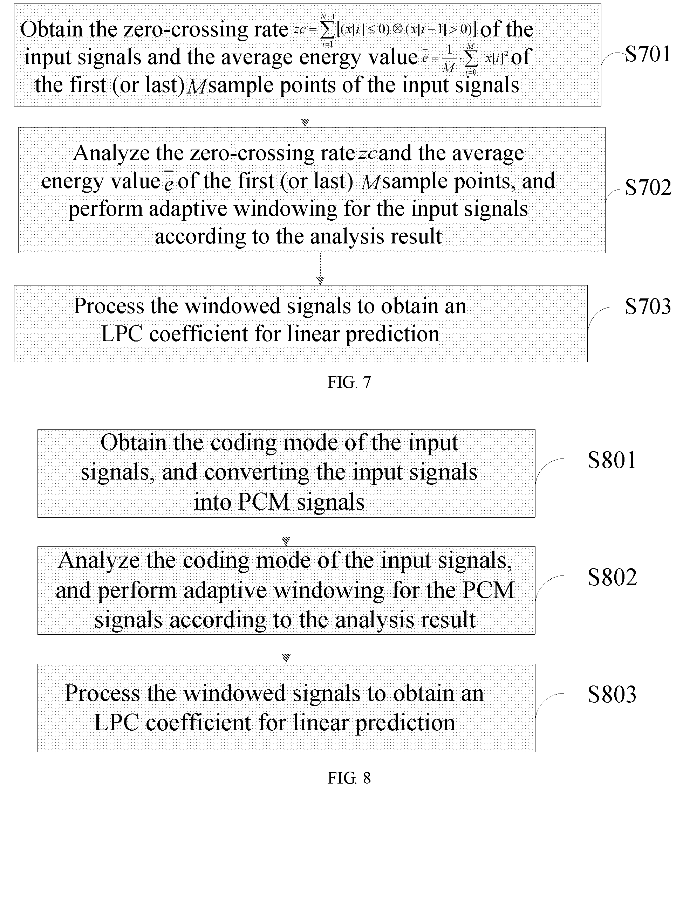

As shown in FIG. 7, an LPC analysis method provided in the fifth example includes the following steps:

S701. Obtain a zero-crossing rate $zc = \sum_{i=1}^{N-1}\left[(x[i] \le 0) \otimes (x[i-1] > 0)\right]$ of an input signal and an average energy value $\overline{e} = \frac{1}{M} \cdot \sum_{i=0}^{M} x[i]^2$ of the first (or last) $M$ sample points, where $x[i]$, $i = 0,1,..., N-1$ refers to the input signal,

$N$ is the number of sample points of the input signal, and $\otimes$ refers to AND operation. The input signal herein refer to signals input for LPC analysis, and may be a frame of signals, or may be a frame of signals plus a segment of signals in a history buffer (such as L sample points in the history buffer, where L is a positive integer, such as 40 or 80, and value of L varies with the type of the codec).

S702. Analyze the zero-crossing rate $zc$ and the average energy value e of the first (or last) $M$ sample points, and perform adaptive windowing for the input signal according to the analysis result.

If the zero-crossing rate $zc$ is greater than or equal to a preset threshold $thr1$, or, if $e$ is less than or equal to a preset threshold $thr2$, the input signal are windowed by using the first window function, namely, by letting $xd[i]$ be $x[i] \cdot w1[i]$, $i = 0,1,..., N-1$, where $xd[i]$ refers to windowed signals and $w1[i]$ is the first window function.

Otherwise, the input signal are windowed by using the second window function, namely, by letting $xd[i]$ be $x[i] \cdot w2[i]$, $i = 0,1,..., N-1$, where $w2[i]$ is the second window function.

The window function $w1[i]$ and the window function $w2[i]$ may be selected through plenty of experiments according to the type of vocoder, and are applicable to different signals. For example, $w1[i]$ is a sine window and $w2[i]$ is a Hamming window; or, $w1[i]$ is a Hamming window and $w2[i]$ is a sine window. The threshold $thr1$ and the threshold $thr2$ may also be selected through plenty of experiments, for example, $thr1 = 15$ and $thr2 = 1023$; or $thr1 = 23$ and $thr2 = 1012$.

In an instance, $thr1 = 17$ and $thr2 = 1012$ ; and, when the frame length $N = 80$ ,

$$w1[i] = \begin{cases} 0.16 + 0.84 \cdot \cos(2 \cdot \pi \cdot (31 - 4 \cdot i)/127), & i = 0,1,...,7 \\ 1, & i = 8,9,...,71 \\ 0.16 + 0.84 \cdot \cos(2 \cdot \pi \cdot (4 \cdot i - 285)/127), & i = 72,73,...,79 \end{cases}$$

$$w2[i] = \begin{cases} 0.26 + 0.74 \cdot \cos(2 \cdot \pi \cdot (31 - 4 \cdot i)/127), & i = 0,1,...,7 \\ 1, & i = 8,9,...,71 \\ 0.26 + 0.74 \cdot \cos(2 \cdot \pi \cdot (4 \cdot i - 285)/127), & i = 72,73,...,79 \end{cases}.$$

When the frame length N = 40,

$$w1[i] = \begin{cases} 0.28 + 0.72 \cdot \cos(2 \cdot \pi \cdot (31 - 8 \cdot i)/127), & i = 0,1,...,3 \\ 1, & i = 4,5,...,35 \\ 0.28 + 0.72 \cdot \cos(2 \cdot \pi \cdot (8 \cdot i - 281)/127), & i = 36,37,...,39 \end{cases}$$

$$w1[i] = \begin{cases} 0.22 + 0.78 \cdot \cos(2 \cdot \pi \cdot (31 - 8 \cdot i)/127), & i = 0,1,...,3 \\ 1, & i = 4,5,...,35 \\ 0.22 + 0.78 \cdot \cos(2 \cdot \pi \cdot (8 \cdot i - 281)/127), & i = 36,37,...,39 \end{cases}.$$

S703. Process the windowed signals to obtain an LPC coefficient for linear prediction. Through the LPC analysis method provided in the fifth example, the zero-crossing rate of the input signal and the average energy value of the first (or last) M sample points of the input signal are obtained, and the input signal are windowed adaptively according to the zero-crossing rate and the average energy value. In this way, the prediction performance of LPC is improved with little increased complexity of coding.

**Example 6**

As shown in FIG. 8, an LPC analysis method provided in the sixth example includes the following steps:

S801. Obtain the coding mode of an input signal, and convert the input signal into Pulse Coding Modulation (PCM) signals, where the input signal are G.711 signals, and the input signal may be A-law signals or mu-law signals.
S802. Analyze the coding mode of the input signal, and perform adaptive windowing for the PCM signals according to the analysis result.

If the coding mode is A-law, the PCM signals are windowed by using the first window function, namely, by letting $xd[i]$ be $x[i] \cdot w[i]$, $i = 0,1,..., N$ -1, where $xd[i]$ refers to windowed signals, $w1[i]$ is the first window function, and $x[i]$ refers to PCM signals.
Otherwise, the PCM signals are windowed by using the second window function, namely, by letting $xd[i]$ be $x[i] \cdot w2[i]$, $i = 0,1,..., N$ -1, where $w2[i]$ is the second window function.
The window function $w1[i]$ and the window function $w2[i]$ may be selected through plenty of experiments according to the type of vocoder, and are applicable to different signals. For example, $w1[i]$ is a sine window and $w2[i]$ is a Hamming window; or, $w1[i]$ is a Hamming window and $w2[i]$ is a sine window.
In an instance, if the coding mode is A-law or mu-law, when the frame length N = 80,

$$w1[i] = \begin{cases} 0.16 + 0.84 \cdot \cos(2 \cdot \pi \cdot (31 - 4 \cdot i)/127), & i = 0,1,...,7 \\ 1, & i = 8,9,...,71 \\ 0.16 + 0.84 \cdot \cos(2 \cdot \pi \cdot (4 \cdot i - 285)/127), & i = 72,73,...,79 \end{cases}$$

$$w2[i] = \begin{cases} 0.26 + 0.74 \cdot \cos(2 \cdot \pi \cdot (31 - 4 \cdot i)/127), & i = 0,1,...,7 \\ 1, & i = 8,9,...,71 \\ 0.26 + 0.74 \cdot \cos(2 \cdot \pi \cdot (4 \cdot i - 285)/127), & i = 72,73,...,79 \end{cases}.$$

When the frame length N = 40,

$$w1[i] = \begin{cases} 0.28 + 0.72 \cdot \cos(2 \cdot \pi \cdot (31 - 8 \cdot i)/127), & i = 0,1,...,3 \\ 1, & i = 4,5,...,35 \\ 0.28 + 0.72 \cdot \cos(2 \cdot \pi \cdot (8 \cdot i - 281)/127), & i = 36,37,...,39 \end{cases}$$

$$w1[i] = \begin{cases} 0.22 + 0.78 \cdot \cos(2 \cdot \pi \cdot (31 - 8 \cdot i)/127), & i = 0,1,...,3 \\ 1, & i = 4,5,...,35 \\ 0.22 + 0.78 \cdot \cos(2 \cdot \pi \cdot (8 \cdot i - 281)/127), & i = 36,37,...,39 \end{cases}.$$

S803. Process the windowed signals to obtain an LPC coefficient for linear prediction. Through the LPC analysis method provided in the sixth example, the coding mode of the input signal is obtained, the input signal are converted into PCM signals, and the input signal are windowed adaptively according to the coding mode. In this way, the prediction performance of LPC is improved with little increased complexity of coding.

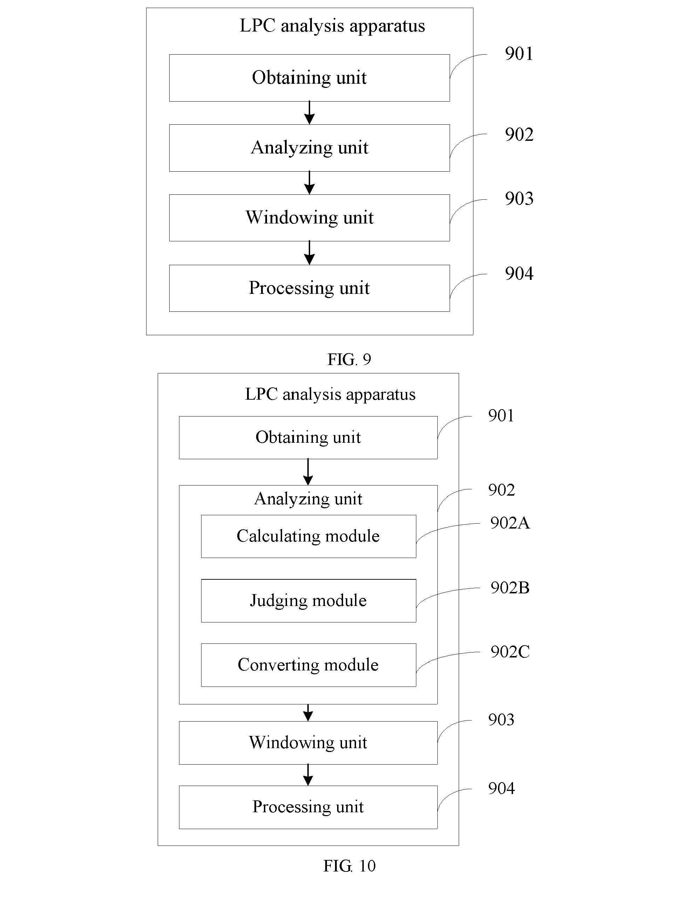

An LPC analysis apparatus is provided in an embodiment of the present invention. As shown in FIG. 9, the apparatus includes:

an obtaining unit 901, configured to obtain signal feature information of at least one sample point of an input signal;
an analyzing unit 902, configured to compare and analyze the signal feature information to obtain an analysis result;
a windowing unit 903, configured to select a window function according to the analysis result to perform adaptive windowing for the input signal and obtain windowed signals; and
a processing unit 904, configured to process the windowed signals to obtain an LPC coefficient for linear prediction.

Through the LPC analysis apparatus provided herein, the input signal are analyzed to obtain an analysis result, and a window function required for windowing is allocated adaptively according to the analysis result. In this way, the prediction performance of LPC is improved with little increased complexity of coding.
As shown in FIG. 10, in another embodiment of the present invention, the analyzing unit 902 includes:

a calculating module 902A, configured to calculate a value of the signal feature information obtained by the obtaining unit 901, where the value of the signal feature information includes the value of signal feature information of a sample point and/or an average of values of signal feature information of multiple points; and
a judging module 902B, configured to judge whether the value of the signal feature information, calculated by the calculating module 902A, is greater than or equal to a threshold, or judge the signal type and/or coding mode of the input signal obtained by the obtaining unit 901.

Further, the analyzing unit 902 mentioned above includes:

a converting module 902C, configured to convert the input signal obtained by the obtaining unit 901 into PCM signals.

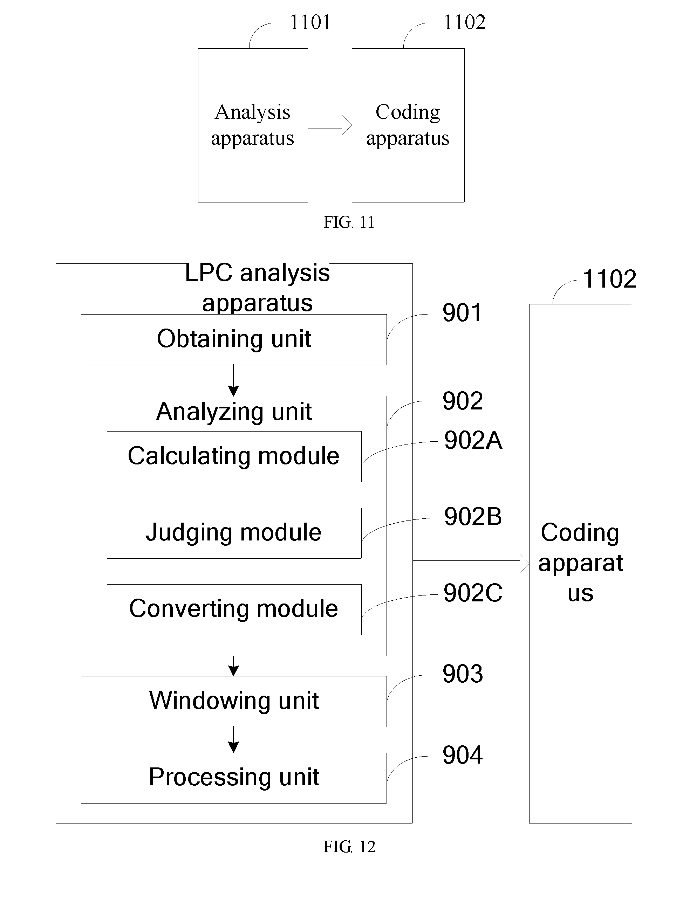

Through the LPC analysis apparatus provided herein, the input signal are analyzed to obtain an analysis result, and a window function required for windowing is allocated adaptively according to the analysis result. In this way, the prediction performance of LPC is improved with little increased complexity of coding.
An LPC system is provided in an embodiment of the present invention. As shown in FIG. 11, the system includes:

an LPC analysis apparatus 1101, configured to: obtain signal feature information of at least one sample point of an input signal; compare and analyze the signal feature information to obtain an analysis result; select a window function according to the analysis result to perform adaptive windowing for the input signal, and obtain windowed signals;

and process the windowed signals to obtain an LPC coefficient; and
a coding apparatus 1102, configured to perform coding according to the LPC coefficient obtained by the LPC analysis apparatus 1101.

Through the LPC system provided herein, the input signal are analyzed to obtain an analysis result, and a window function required for windowing is allocated adaptively according to the analysis result to obtain an LPC coefficient, and then coding is performed according to the LPC coefficient. In this way, the prediction performance of LPC is improved with little increased complexity of coding.

As shown in FIG. 12, the LPC analysis apparatus 1101 in another embodiment of the present invention has the same structure as the LPC analysis apparatus in the above mentioned embodiment, and is not described in detail herein any further.

Through the LPC system provided herein, the input signal are analyzed to obtain an analysis result, and a window function required for windowing is allocated adaptively according to the analysis result to obtain an LPC coefficient, and then coding is performed according to the LPC coefficient. In this way, the prediction performance of LPC is improved with little increased complexity of coding.

Persons of ordinary skill in the art should understand that all or part of the steps of the method provided in the embodiments mentioned above may be implemented by a program instructing relevant hardware. The program may be stored in computer readable storage media. When the program runs, it may execute the steps of the method specified in any embodiment mentioned above. The storage media may be a magnetic disk, CD-ROM, Read-Only Memory (ROM), or Random Access Memory (RAM).

The above descriptions are merely exemplary embodiments of the present invention, but not intended to limit the scope of the present invention as defined by the appended claims.

Any modifications, variations or replacement that can be easily derived by those skilled in the art may fall within the scope of the present invention. Therefore, the protection scope of the present invention is subject to the appended claims.

**Claims**

1. A Linear Prediction Coding, LPC, analysis method, comprising:

   obtaining (S201) signal feature information of at least one sample point of an input voice signal;
   comparing and analyzing (S202) the signal feature information to obtain an analysis result;
   selecting a window function, according to the analysis result, to perform adaptive windowing for the input voice signal and obtain a windowed voice signal; and
   processing (S203) the windowed voice signal to obtain an LPC coefficient for linear prediction;
   wherein obtaining (S201) signal feature information of at least one sample point of an input voice signal comprises: obtaining (S201) an amplitude value $[x[0]|$ of a first sample point and an amplitude value $|x[N$ -1$]|$ of a last sample point of the input voice signal, where $x[i]$, $i = 0,1,..., N$ -1 are sample points of the input voice signal and N is the number of sample points of the input voice signal; and
   wherein comparing and analyzing (S202) the signal feature information to obtain an analysis result and selecting a window function, according to the analysis result, to perform adaptive windowing for the input voice signal and obtain a windowed voice signal comprises:

      analyzing (S202) the points amplitude values $[x[0]|$ and $|x[N$-1$]|$ of the sample points and perform adaptive windowing for the input voice signal according to the analysis result, wherein when the number of sample points of the input voice signal is 80,
      if the amplitude value $|x[0]|$ of the first sample point of the input voice signal is less than a preset threshold *thr,* the first 8 points of the window function are set as: $w(n) = 0.26 + 0.74 \cdot \cos(2 \cdot \pi (31-4 \cdot n)/127)$, $n = 0,1,2,...,7$; otherwise, the first 8 points of the window function are set as: $w(n)=0.16+0.84 \cdot \cos(2 \cdot \pi (31-4 \cdot n)/127)$, $n = 0,1,2,...,7$;
      the 9th to 72nd points of the window function are set as $w(n) = 1$, $n = 8,...,71$;
      if the amplitude value $|x[79]|$ of the last sample point of the input voice signal is less than the preset threshold *thr,* the last 8 points of the window function are set as: $w(n) = 0.26 + 0.74 \cdot \cos(2 \cdot \pi(4 \cdot n-285)/127)$, $n = 72,73,74,...,79$; otherwise, the last 8 points of the window function are set as: $w(n)=0.16+0.84 \cdot \cos(2 \cdot \pi (4 \cdot n - 285)/127)$, $n = 72,73,74,...,79$; and wherein the sample points of the input voice signal $x(n)$, $n = 0,1,...,78,79$ are windowed by using the window function iw($n$), in $= 0,1,...,78,79$ to obtain the the windowed voice signal.

2. The LPC analysis method according to claim 1, wherein the threshold *thr* is 128 or 157.

3. The LPC analysis method according to claim 1, wherein the obtaining (S201) an amplitude value [$x$[0]| of a first sample point and an amplitude value |$x$[$N$-1]| of a last sample point of an input voice signal comprises:

   converting the input voice signal into a Pulse Coding Modulation, PCM, voice signal; and
   obtaining an amplitude value [$x$[0]| of a first sample point and an amplitude value |$x$[$N$-1]| of a last sample point of the converted input voice signal.

4. A Linear Prediction Coding, LPC, analysis apparatus (1101), comprising:

   an obtaining unit (901), configured to obtain signal feature information of at least one sample point of an input voice signal;
   an analyzing unit (902), configured to compare and analyze the signal feature information to obtain an analysis result;
   a windowing unit (903), configured to select a window function according to the analysis result to perform adaptive windowing for the input voice signal and obtain a windowed voice signal; and
   a processing unit (904), configured to process the windowed voice signal to obtain an LPC coefficient for linear prediction;
   wherein to obtain signal feature information of at least one sample point of an input voice signal comprises to obtain an amplitude value [$x$[0]| of a first sample point and an amplitude value |$x$[$N$-1]| of a last sample point of the input voice signal, where $x[i]$, $i = 0,1,..., N$ -1 are sample points of the input voice signal and N is the number of sample points of the input voice signal;
   wherein to compare and analyze the signal feature information to obtain an analysis result and to select a window function according to the analysis result to perform adaptive windowing for the input voice signal and obtain a windowed voice signal comprises to analyze the amplitude values |x[0]| and |x[N-1]| of the sample points and to perform adaptive windowing for the input voice signal according to the analysis result; wherein when the number of sample points of the input voice signal is 80,
   if the amplitude value |x[0]| of the first sample point of the input voice signal is less than a preset threshold *thr,* the first 8 points of the window function are set as: $w(n) = 0.26+0.74. \cos(2 \cdot \pi (31- 4 \cdot n)/127)$, $n = 0,1,2,...,7$ ; otherwise, the first 8 points of the window function are set as: $w(n) = 0.16+0.84 \cdot \cos(2 \cdot \pi (31-4 \cdot n/127)$, $n = 0,1,2,...,7$ ;
   the 9th to 72nd points of the window function are set as $w(n) = 1$, $n = 8,...,71$;
   if the amplitude value |x[79]| of the last sample point of the input voice signal is less than the preset threshold *thr*, the last 8 points of the window function are set as: $w(n) = 0.26 + 0.74. \cos(2 \cdot \pi \cdot (4 \cdot n-285)/127)$, $n = 72,73,74,...,79$ ; otherwise, the last 8 points of the window function are set as: $w(n) = 0.16+0.84 \cdot \cos(2 \cdot \pi (4 \cdot n-285)/127)$, $n = 72,73,74,...,79$ ; and wherein the sample points of the input voice signal $x(n)$, $n = 0,1,...,78,79$ are windowed by using the window function $w(n)$, $n = 0,1,...,78,79$ to obtain the windowed voice signal.

5. The LPC analysis apparatus according to claim 4, wherein the threshold *thr* is 128 or 157.

6. The LPC analysis apparatus according to claim 4, wherein the analyzing unit (902) further comprises:

   a converting module (902C), configured to convert the input voice signal obtained by the obtaining unit into a Pulse Coding Modulation (PCM) voice signal.

7. A Linear Prediction Coding, LPC, system, comprising:

   an LPC analysis apparatus (1101) according to claim 4 or 5 or 6; and
   a coding apparatus (1102), configured to perform coding according to the LPC coefficient obtained by the LPC analysis apparatus (1101).

**Patentansprüche**

1. Analyseverfahren für lineare Prädiktionscodierung, LPC-Analyseverfahren, das Folgendes umfasst:

   Erhalten (S201) von Signalmerkmalsinformationen wenigstens eines Abtastpunkts eines Eingangssprachsignals;

Vergleichen und Analysieren (S202) der Signalmerkmalsinformationen, um ein Analyseergebnis zu erhalten;

Auswählen einer Fensterfunktion gemäß dem Analyseergebnis, um adaptives Fenstern für das Eingangssprachsignal auszuführen und ein gefenstertes Sprachsignal zu erhalten; und

Verarbeiten (S203) des gefensterten Sprachsignals, um einen LPC-Koeffizienten für lineare Prädiktion zu erhalten;

wobei Erhalten (S201) von Signalmerkmalsinformationen wenigstens eines Abtastpunkts eines Eingangssprachsignals Folgendes umfasst: Erhalten (S201) eines Amplitudenwerts $|x[0]|$ eines ersten Abtastpunkts und eines Amplitudenwerts $|x[N- 1]|$ eines letzten Abtastpunkts des Eingangssprachsignals, wobei $x[i]$, i = 0, 1, ..., $N$ - 1, Abtastpunkte des Eingangssprachsignals sind und N die Anzahl von Abtastpunkten des Eingangssprachsignals ist; und

wobei Vergleichen und Analysieren (S202) der Signalmerkmalsinformationen, um ein Analyseergebnis zu erhalten, und Auswählen einer Fensterfunktion gemäß dem Analyseergebnis, um adaptives Fenstern für das Eingangssprachsignal auszuführen und ein gefenstertes Sprachsignal zu erhalten, Folgendes umfasst:

Analysieren (S202) der Amplitudenwerte $|x[0]|$ und $|x[N - 1]|$ der Abtastpunkte und Ausführen von adaptivem Fenstern für das Eingangssprachsignal gemäß dem Analyseergebnis, wobei dann, wenn die Anzahl von Abtastpunkten des Eingangssprachsignals 80 ist,

falls der Amplitudenwert $|x[0]|$ des ersten Abtastpunkts des Eingangssprachsignals kleiner ist als ein voreingestellter Schwellenwert *thr*, die ersten 8 Punkte der Fensterfunktion eingestellt werden als: $w(n)$ = 0,26 + 0,74 · cos(2 · $\pi$ · (31 - 4 · $n$)/127), $n$ = 0, 1, 2, ..., 7; andernfalls werden die ersten 8 Punkte der Fensterfunktion eingestellt als: $w(n)$ = 0,16 + 0,84 · cos(2 · $\pi$ · (31- 4 · $n$)/127), $n$ = 0, 1, 2, ..., 7; die 9. bis 72. Punkte der Fensterfunktion werden eingestellt als $w(n)$ = 1, $n$ = 8,..., 71;

falls der Amplitudenwert $|x[79]|$ des letzten Abtastpunkts des Eingangssprachsignals kleiner ist als der voreingestellte Schwellenwert *thr*, die letzten 8 Punkte der Fensterfunktion eingestellt werden als: $w(n)$ = 0,26 + 0,74 · cos(2 · $\pi$ · (4 · $n$ - 285)/127), n = 72, 73, 74, ..., 79; andernfalls die letzten 8 Punkte der Fensterfunktion eingestellt werden als: $w(n)$ = 0,16 + 0,84 · cos(2 · $\pi$ · (4 · $n$ - 285)/127), n = 72, 73, 74, ..., 79; und wobei die Abtastpunkte des Eingangssprachsignals $x(n)$, n = 0, 1, ..., 78, 79, durch Verwendung der Fensterfunktion $w(n)$, $n$ = 0, 1, ..., 78, 79 gefenstert werden, um das gefensterte Sprachsignal zu erhalten.

2. LPC-Analyseverfahren nach Anspruch 1, wobei der Schwellenwert *thr* 128 oder 157 ist.

3. LPC-Analyseverfahren nach Anspruch 1, wobei das Erhalten (S201) eines Amplitudenwerts $|x[0]|$ eines ersten Abtastpunkts und eines Amplitudenwerts $|x[N - 1]|$ eines letzten Abtastpunkts eines Eingangssprachsignals Folgendes umfasst:

Umsetzen des Eingangssprachsignals in ein Pulscodierungsmodulations-Sprachsignal, PCM-Sprachsignal; und

Erhalten eines Amplitudenwerts $|x[0]|$ eines ersten Abtastpunkts und eines Amplitudenwerts $|x[N - 1]|$ eines letzten Abtastpunkts des umgesetzten Eingangssprachsignals.

4. Analysevorrichtung (1101) für lineare Prädiktionscodierung, LPC-Analysevorrichtung, die Folgendes umfasst:

eine Erhalteeinheit (901), die konfiguriert ist, Signalmerkmalsinformationen wenigstens eines Abtastpunkts eines Eingangssprachsignals zu erhalten;

eine Analyseeinheit (902), die konfiguriert ist, die Signalmerkmalsinformationen zu vergleichen und zu analysieren, um ein Analyseergebnis zu erhalten;

eine Fensterungseinheit (903), die konfiguriert ist, eine Fensterfunktion gemäß dem Analyseergebnis auszuwählen, um adaptives Fenstern für das Eingangssprachsignal auszuführen und ein gefenstertes Sprachsignal zu erhalten; und

eine Verarbeitungseinheit (904), die konfiguriert ist, das gefensterte Sprachsignal zu verarbeiten, um einen LPC-Koeffizienten für lineare Prädiktion zu erhalten;

wobei das Erhalten von Signalmerkmalsinformationen wenigstens eines Abtastpunkts eines Eingangssprachsignals umfasst, Folgendes zu erhalten:

einen Amplitudenwert $|x[0]|$ eines ersten Abtastpunkts und einen Amplitudenwert $|x[N - 1]|$ eines letzten Abtastpunkts des Eingangssprachsignals, wobei $x[i]$, $i$ = 0, 1, ..., $N$ - 1, Abtastpunkte des Eingangssprachsignals sind und N die Anzahl von Abtastpunkten des Eingangssprachsignals ist;

wobei das Vergleichen und Analysieren der Signalmerkmalsinformationen, um ein Analyseergebnis zu erhalten und um eine Fensterfunktion gemäß dem Analyseergebnis auszuwählen, um adaptives Fenstern für das Eingangssprachsignal auszuführen und ein gefenstertes Sprachsignal zu erhalten, umfasst, die Amplitudenwerte |x[0]| und |x[N- 1]| der Abtastpunkte zu analysieren und adaptives Fenstern für das Eingangssprachsignal gemäß dem Analyseergebnis auszuführen;

wobei dann, wenn die Anzahl von Abtastpunkten in dem Eingangssprachsignal gleich 80 ist,

falls der Amplitudenwert |x[0]| des ersten Abtastpunkts des Eingangssprachsignals kleiner ist als ein voreingestellter Schwellenwert *thr*, die ersten 8 Punkte der Fensterfunktion eingestellt werden als: $w(n) = 0,26 + 0,74 \cdot \cos(2 \cdot \pi \cdot (31 - 4 \cdot n)/127)$, $n = 0, 1, 2, ..., 7$; andernfalls werden die ersten 8 Punkte der Fensterfunktion eingestellt als: $w(n) = 0,16 + 0,84 \cdot \cos(2 \cdot \pi \cdot (31 - 4 \cdot n)/127)$, $n = 0, 1, 2, ..., 7$;

die 9. bis 72. Punkte der Fensterfunktion werden eingestellt als $w(n) = 1$, $n = 8, ..., 71$;

falls der Amplitudenwert |x[79]| des letzten Abtastpunkts des Eingangssprachsignals kleiner ist als der voreingestellte Schwellenwert *thr*, die letzten 8 Punkte der Fensterfunktion eingestellt werden als: $w(n) = 0,26 + 0,74 \cdot \cos(2 \cdot \pi \cdot (4 \cdot n - 285)/127)$, $n = 72, 73, 74, ..., 79$; andernfalls die letzten 8 Punkte der Fensterfunktion eingestellt werden als: $w(n) = 0,16 + 0,84 \cdot \cos(2 \cdot \pi \cdot (4 \cdot n - 285)/127)$, $n = 72, 73, 74, ..., 79$; und wobei die Abtastpunkte des Eingangssprachsignals $x(n)$, $n = 0, 1, ..., 78, 79$, durch Verwendung der Fensterfunktion $w(n)$, $n = 0, 1, ..., 78, 79$ gefenstert werden, um das gefensterte Sprachsignal zu erhalten.

5. LPC-Analysevorrichtung nach Anspruch 4, wobei der Schwellenwert *thr* 128 oder 157 ist.

6. LPC-Analysevorrichtung nach Anspruch 4, wobei die Analyseeinheit (902) ferner Folgendes umfasst:

ein Umsetzungsmodul (902C), das konfiguriert ist, das Eingangssprachsignal, das durch die Erhalteeinheit erhalten wird, in ein Pulscodierungsmodulations-Sprachsignal, PCM-Sprachsignal, umzusetzen.

7. System für lineare Prädiktionscodierung, LPC-System, das Folgendes umfasst:

eine LPC-Analysevorrichtung (1101) nach Anspruch 4 oder 5 oder 6; und
eine Codierungsvorrichtung (1102), die konfiguriert ist, Codierung gemäß dem LPC-Koeffizienten, der durch die LPC-Analysevorrichtung (1101) erhalten wird, auszuführen.

**Revendications**

1. Procédé d'analyse à codage prédictif linéaire, LPC, comprenant :

l'obtention (S201) d'informations de caractéristique de signal d'au moins un point d'échantillon d'un signal vocal d'entrée ;
la comparaison et l'analyse (S202) des informations de caractéristique de signal pour obtenir un résultat d'analyse ;
la sélection d'une fonction de fenêtre, en fonction du résultat d'analyse, pour exécuter un fenêtrage adaptatif du signal vocal d'entrée et obtenir un signal vocal fenêtré ; et
le traitement (S203) du signal vocal fenêtré pour obtenir un coefficient LPC de prédiction linéaire ;
dans lequel l'obtention (S201) d'informations de caractéristique de signal d'au moins un point d'échantillon d'un signal vocal d'entrée comprend : l'obtention (S201) d'une valeur d'amplitude |x[0]| d'un premier point d'échantillon et d'une valeur d'amplitude |x[N-1]| d'un dernier point d'échantillon du signal vocal d'entrée, où x[i], i=0,1,...,N-1 sont des points d'échantillon du signal vocal d'entrée et N est le nombre de points d'échantillon du signal vocal d'entrée ; et
dans lequel la comparaison et l'analyse (S202) des informations de caractéristique de signal pour obtenir un résultat d'analyse et la sélection d'une fonction de fenêtre, en fonction du résultat d'analyse, pour exécuter un fenêtrage adaptatif du signal vocal d'entrée et obtenir un signal vocal fenêtré comprend :

l'analyse (S202) des valeurs d'amplitude |x[0]| et |x[N-1]| des points d'échantillon et l'exécution d'un fenêtrage adaptatif du signal vocal d'entrée en fonction du résultat d'analyse, dans lequel quand le nombre de points d'échantillon du signal vocal d'entrée est 80,
si la valeur d'amplitude |x[0]| du premier point d'échantillon du signal vocal d'entrée est inférieure à un seuil prédéfini *thr,* les 8 premiers points de la fonction de fenêtre sont définis à : $w(n) = 0,26 + 0,74 \cdot \cos(2 \cdot \pi \cdot (31 - 4 \cdot n)/127)$, $n = 0, 1, 2, ..., 7$ ; sinon, les 8 premiers points de la fonction de fenêtre sont définis à : $w(n) =$

0,16 + 0,84.cos(2.π.(31 - 4.*n*)/127), *n* = 0, 1, 2, ..., 7 ;
les 9ᵉ au 72ᵉ points de la fonction de fenêtre sont définis à *w*(*n*) = 1, *n* = 8, ..., 71 ;
si la valeur d'amplitude |*x*[79]| du dernier point d'échantillon du signal vocal d'entrée est inférieure au seuil prédéfini *thr,* les 8 derniers points de la fonction de fenêtre sont définis à : *w*(*n*) = 0,26 + 0,74.cos(2. π.(4.*n* - 285)/127), *n* = 72, 73, 74, ..., 79 ; sinon, les 8 derniers points de la fonction de fenêtre sont définis à : *w*(*n*) = 0,16 + 0,84.cos(2. π.(4.*n* - 285)/127), *n* = 72, 73, 74, ..., 79; et dans lequel les points d'échantillon du signal vocal d'entrée *x(n)*, *n* = 0, 1, ..., 78, 79 sont fenêtrés en utilisant la fonction de fenêtre *w*(*n*), *n* = 0, 1, ..., 78, 79 pour obtenir le signal vocal fenêtré.

2. Procédé d'analyse LPC selon la revendication 1, dans lequel le seuil *thr* est 128 ou 157.

3. Procédé d'analyse LPC selon la revendication 1, dans lequel l'obtention (S201) d'une valeur d'amplitude |*x*[0]| d'un premier point d'échantillon et d'une valeur d'amplitude |*x*[N-1]| d'un dernier point d'échantillon d'un signal vocal d'entrée comprend :

   la conversion du signal vocal d'entrée en un signal vocal à modulation par codage d'impulsions, PCM ; et
   l'obtention d'une valeur d'amplitude |*x*[0]| d'un premier point d'échantillon et d'une valeur d'amplitude |*x*[N-1]| d'un dernier point d'échantillon du signal vocal d'entrée converti.

4. Appareil d'analyse à codage prédictif linéaire, LPC, (1101), comprenant :

   une unité d'obtention (901), configurée pour obtenir des informations de caractéristique de signal d'au moins un point d'échantillon d'un signal vocal d'entrée ;
   une unité d'analyse (902), configurée pour comparer et analyser les informations de caractéristique de signal pour obtenir un résultat d'analyse ;
   une unité de fenêtrage (903), configurée pour sélectionner une fonction de fenêtre, en fonction du résultat d'analyse, pour exécuter un fenêtrage adaptatif du signal vocal d'entrée et obtenir un signal vocal fenêtré ; et
   une unité de traitement (904), configurée pour traiter le signal vocal fenêtré pour obtenir un coefficient LPC de prédiction linéaire ;
   dans lequel l'obtention d'informations de caractéristique de signal d'au moins un point d'échantillon d'un signal vocal d'entrée comprend l'obtention d'une valeur d'amplitude |*x*[0]| d'un premier point d'échantillon et d'une valeur d'amplitude |*x*[N-1]| d'un dernier point d'échantillon du signal vocal d'entrée, où *x*[*i*], *i*=0, 1, ..., *N-1* sont des points d'échantillon du signal vocal d'entrée et N est le nombre de points d'échantillon du signal vocal d'entrée ;
   dans lequel la comparaison et l'analyse des informations de caractéristique de signal pour obtenir un résultat d'analyse et la sélection d'une fonction de fenêtre en fonction du résultat d'analyse pour exécuter un fenêtrage adaptatif du signal vocal d'entrée et obtenir un signal vocal fenêtré comprend l'analyse des valeurs d'amplitude |*x*[0]| et |*x*[N-1]| des points d'échantillon et l'exécution d'un fenêtrage adaptatif du signal vocal d'entrée en fonction du résultat d'analyse ;
   dans lequel quand le nombre de points d'échantillon du signal vocal d'entrée est 80, si la valeur d'amplitude |*x*[0]| du premier point d'échantillon du signal vocal d'entrée est inférieure à un seuil prédéfini *thr,* les 8 premiers points de la fonction de fenêtre sont définis à : *w*(*n*) = 0,26 + 0,74.cos(2. π.(31 - 4.*n*)/127), *n* = 0, 1, 2, ..., 7 ; sinon, les 8 premiers points de la fonction de fenêtre sont définis à : *w*(*n*) = 0,16 + 0,84.cos(2.π.(31 - 4.*n*)/127), *n* = 0, 1, 2, ..., 7 ;
   les 9ᵉ au 72ᵉ points de la fonction de fenêtre sont définis à *w*(*n*) = 1, *n* = 8, ..., 71 ;
   si la valeur d'amplitude |*x*[79]| du dernier point d'échantillon du signal vocal d'entrée est inférieure au seuil prédéfini *thr,* les 8 derniers points de la fonction de fenêtre sont définis à : *w*(*n*) = 0,26 + 0,74.cos(2. π.(4.*n* - 285)/127), *n* = 72, 73, 74, ..., 79 ; sinon, les 8 derniers points de la fonction de fenêtre sont définis à : *w*(*n*) = 0,16 + 0,84.cos(2. π.(4.*n* - 285)/127), *n* = 72, 73, 74, ..., 79; et dans lequel les points d'échantillon du signal vocal d'entrée *x*(*n*), *n* = 0, 1, ..., 78, 79 sont fenêtrés en utilisant la fonction de fenêtre *w*(*n*), *n* = 0, 1, ..., 78, 79 pour obtenir le signal vocal fenêtré.

5. Appareil d'analyse LPC selon la revendication 4, dans lequel le seuil *thr* est 128 ou 157.

6. Appareil d'analyse LPC selon la revendication 4, dans lequel l'unité d'analyse (902) comprend en outre :

   un module de conversion (902C), configuré pour convertir le signal vocal d'entrée obtenu par l'unité d'obtention en un signal vocal à modulation par codage d'impulsions, PCM.

**7.** Système de codage prédictif linéaire, LPC, comprenant :

un appareil d'analyse LPC (1101) selon la revendication 4 ou 5 ou 6 ; et
un appareil de codage (1102) configuré pour exécuter un codage selon le coefficient LPC obtenu par l'appareil d'analyse LPC (1101).

Obtain signal feature information of at least one sample point of input signals — S101

Compare and analyze the signal feature information to obtain an analysis result — S102

Select a window function according to the analysis result to perform adaptive windowing for the input signals and obtain windowed signals — S103

Process the windowed signals to obtain an LPC coefficient for linear prediction — S104

FIG. 1

Obtain the amplitude value $|x[0]|$ of the first sample point and the amplitude value $|x[N-1]|$ of the last sample point of the input signals — S201

Analyze the sample point amplitude values $|x[N-1]|$ and $|x[0]|$ and perform adaptive windowing for the input signals according to the analysis result — S202

Process the windowed signals to obtain an LPC coefficient for linear prediction — S203

FIG. 2

Obtain the amplitude value of the first sample point of the input signals $\big|x[0]\big|$ — S301

Analyze the sample point amplitude value $\big|x[0]\big|$ and perform adaptive windowing for the input signals according to the analysis result — S302

Process the windowed signals to obtain an LPC coefficient for linear prediction — S303

FIG. 3

Obtain the average amplitude value $\bar{x} = \dfrac{1}{M} \cdot \sum\limits_{i=0}^{M} |x[i]|$ of the first (or last) $M$ sample points of the input signals — S401

Analyze the average amplitude value $\bar{x}$ of the first (or last) $M$ sample points, and perform adaptive windowing for the input signals according to the analysis result — S402

Process the windowed signals to obtain an LPC coefficient for linear prediction — S403

FIG. 4

Obtain the average energy value of the first (or last) $M$ sample points of the input signals

$$\bar{e} = \frac{1}{M} \cdot \sum_{i=0}^{M} x[i]^2$$

S501

Analyze the average amplitude value $\bar{e}$ of the first (or last) $M$ sample points, and perform adaptive windowing for the input signals according to the analysis result

S502

Process the windowed signals to obtain an LPC coefficient for linear prediction

S503

FIG. 5

Obtain the zero-crossing rate $zc = \sum_{i=1}^{N-1}[(x[i] \leq 0) \otimes (x[i-1] > 0)]$ of the input signal

S601

Analyze the zero-crossing rate $zc$, and perform adaptive windowing for the input signals according to the analysis result

S602

Process the windowed signals to obtain an LPC coefficient for linear prediction

S603

FIG. 6

Obtain the zero-crossing rate $zc = \sum_{i=1}^{N-1}[(x[i] \le 0) \otimes (x[i-1] > 0)]$ of the input signals and the average energy value $\bar{e} = \frac{1}{M} \cdot \sum_{i=0}^{M} x[i]^2$ of the first (or last) $M$ sample points of the input signals — S701

Analyze the zero-crossing rate $zc$ and the average energy value $\bar{e}$ of the first (or last) $M$ sample points, and perform adaptive windowing for the input signals according to the analysis result — S702

Process the windowed signals to obtain an LPC coefficient for linear prediction — S703

FIG. 7

Obtain the coding mode of the input signals, and converting the input signals into PCM signals — S801

Analyze the coding mode of the input signals, and perform adaptive windowing for the PCM signals according to the analysis result — S802

Process the windowed signals to obtain an LPC coefficient for linear prediction — S803

FIG. 8

LPC analysis apparatus

Obtaining unit — 901

Analyzing unit — 902

Windowing unit — 903

Processing unit — 904

FIG. 9

LPC analysis apparatus

Obtaining unit — 901

Analyzing unit — 902

Calculating module — 902A

Judging module — 902B

Converting module — 902C

Windowing unit — 903

Processing unit — 904

FIG. 10

1101

1102

Analysis apparatus

Coding apparatus

FIG. 11

LPC analysis apparatus

901

Obtaining unit

902

Analyzing unit

902A

Calculating module

902B

Judging module

902C

Converting module

903

Windowing unit

904

Processing unit

1102

Coding apparatus

FIG. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6311154 B1
- US 2007118368 A1
- US 2006173675 A1
- US 6978236 B1
- WO 9857436 A
- US 2008270124 A1
- US 20030139830 A1
- US 20080312914 A1

### Non-patent literature cited in the description

- **LEV O et al.** discloses that we present a low bit rate speech coder based on a long-term model (LTM) for voiced speech, and on the WI coder. *Low Bit-Rate Speech Coder Based on a Long-Term Model*